# EUROPEAN PATENT APPLICATION

(11) **EP 0 847 086 A2**
(43) Date of publication of application: **10.06.1998**
(21) Application number: 97121138.8
(22) Date of filing: 02.12.1997
(51) Int. Cl.: H01L 23/495

(54) **Improvements in or relating to semiconductor devices**

(30) Priority: 03.12.1996 US 32299 P
(71) Applicant: Texas Instruments Incorporated, Dallas, Texas 75265 (US)
(72) Inventor: Gelsomini, Tito, Missouri City, Texas 77459 (US); Liverini, Vito, Missouri City, Texas 77459 (US); Imondi, Giuliano, Rieti 02100 (IT)
(74) Representative: Schwepfinger, Karl-Heinz, Dipl.-Ing.

(57) **Abstract**

A method and apparatus (50) double the memory capacity of a single-package semiconductor memory device (10) using a bump bonding process applied to mirror imaged chips. The method includes and resulting apparatus results from the steps of forming a first chip (10) comprising a first set of pads (12) according to a predetermined set of masks (20). Generating a set of mirror-imaged masks (24) comprising a mirror image of the predetermined set of masks (20) is a next step of the present method. Then, the invention includes forming a second chip (30) comprising a second set of pads (32) according to the set of mirror-imaged masks (24). Connecting the first chip (10) and the second chip (30) to a single package lead frame (40) can then occur such that the first chip (10) and the second chip (30) face opposite sides of the single package lead frame (40) for functionally equivalent ones of the first set of pins (12) and the second set of pins (32) to share a common lead of said single package lead frame (40). Control circuitry (60) selectively controls whether single packaged semiconductor memory device (50) provides single capacity or double capacity operation.

## Description

### TECHNICAL FIELD OF THE INVENTION

The present invention relates generally to semiconductor devices and, more particularly, to a method of doubling the memory capacity of a single-packaged semiconductor memory device.

### BACKGROUND OF THE INVENTION

Integrated circuit components are performing increasingly complex operations. These operations make necessary more sophisticated processing, signal communications, and data storage capabilities. It is important, as part of this development, that random access and other memory capacities keep pace by providing sufficient storage capacities. Designing memories with greater storage capacities generally consumes time and expends significant research and development resources. If it were possible to increase the storage capacity of a single-package DRAM or other memory device without expending significant research and development resources, the speed and capabilities of the associated processes and electronic devices could be improved without the costs that accompany normal component development efforts.

Because of circuit board space and packaging limitations existing with new electronic devices, it is not practical to simply add more than one memory device to a single-packaged, integrated circuit component. It is not practical, in many situations and for many reasons, to simply increase the number of devices supporting a given memory application.

In recent years, development of increased memory capacity has been such that a four-fold increase in memory capacity for a DRAM device requires three to five years. Because of the faster developing demand for processing complex instructions and performing increasingly sophisticated operations, it may not be practical to simply wait for DRAM or other memory device development at this pace.

### SUMMARY OF THE INVENTION

In response to the above limitations, there is the need for a method to increase the capacity of a semiconductor memory device using the existing circuit designs, thereby avoiding the need to wait for design technology developments.

There is also the need for a method and the apparatus resulting from the method that increases the memory capacity of a semiconductor memory devices without consuming valuable circuit board space and without requiring an extensive packaging or circuit redesign for the associated integrated circuit.

The present invention, therefore, provides a method of and the apparatus resulting from the method of packaging of semiconductor memory device using a bump bonding process applied to mirror aged chips. The present invention overcomes or substantially reduces the expense, space limitations and design development constraints of prior art memory device packaging methods for increasing semiconductor memory device capacities.

According to one aspect of the present invention, there is provided a method of assembling a packaged semiconductor memory device. The method includes the steps of providing a first device having a first set of pads. Then, the invention includes providing a second device having a second set of pads formed according a mirror-image of the first set of pads. Bonding the first device and the second device to a lead frame can then occur so that the active region of the first device and the second device substantially face opposite sides of the lead frame for functionally equivalent ones of the first set of pads and the second set of pads to share a common lead of the lead frame.

A technical advantage that the present invention provides a double capacity memory device that starts from the single capacity device and achieves the desired results of double capacity without any major change in the design of the single-capacity memory device and without the need for extensive circuit redesign.

Another technical advantage of the present invention is that it applies to not only DRAMs, but also to a wide variety of semiconductor memory devices such as SRAMs, flash EPROMs, OPT-EPROMs, EEPROMs, Videorams, FMEMs, and others.

Yet another technical advantage of the present invention is the ability to build the double capacity memory device essentially immediately after a first single-package device is available for mass production. By generating a second set of masks to produce a chip that is quite identical to the one originally designed, but a mirror image, the present invention provides a low-cost and reliable way to double the memory capacity of a semiconductor memory device.

Another technical advantage of the present invention is that it may make effective use of "bump bonding" technology to bond two chips facing a dedicated lead frame from both sides. Since all device pad functions may be placed in corresponding locations in the mirror-imaged circuits, when the two mirrored chips face one another, the majority of functions in the two chips may be connected to the same level on the dedicated lead frame.

Another technical advantage of the present invention is that it requires only a minimum amount of modification in a given chip design to provide the characteristics of achieving a memory device having the ability to double its memory capacity.

The present invention makes possible the fabrication of a mirror-imaged circuit that possesses full compatibility with the commodity device. The mirror-imaged device may also include all of the layout geometries that may be necessary for proper use of the bond technology for bump bonding. This and other special features may be included in the various memory devices that employ the novel teachings of the present invention.

### BRIEF DESCRIPTION OF THE DRAWINGS

For a more complete understanding of the present invention and the advantages thereof, reference is now made to the following description which is to be taken in conjunction with the accompanying drawings and wherein:
FIGURE 1 shows a first memory chip comprising a first set of pads formed according to a predetermined set of masks;
FIGURE 2 conceptually illustrates the formation of mirror-imaged masks formed from a mirror image of the predetermined set of masks of the FIGURE 1 memory chip;
FIGURE 3 illustrates a second memory chip having a second set of pads and formed from the set of mirror-imaged masks according to the teachings of FIGURE 2;
FIGURE 4 shows an example of a lead frame that may be used with the first memory chip and second memory chip of FIGUREs 1 and 3, respectively;
FIGURE 5 shows the first chip and the second chip bonded to a single package lead frame according to the teachings of the present invention;
FIGURE 6 depicts a logic circuit diagram illustrating the various possible modes of use for the double capacity memory device of the present invention; and
FIGURE 7 provides a summary table of characteristics of the double capacity memory device of the present invention.

### DETAILED DESCRIPTION OF THE INVENTION

Preferred embodiments of the present invention are illustrated in the FIGUREs like numerals being used to refer to like and corresponding parts of the various drawings.

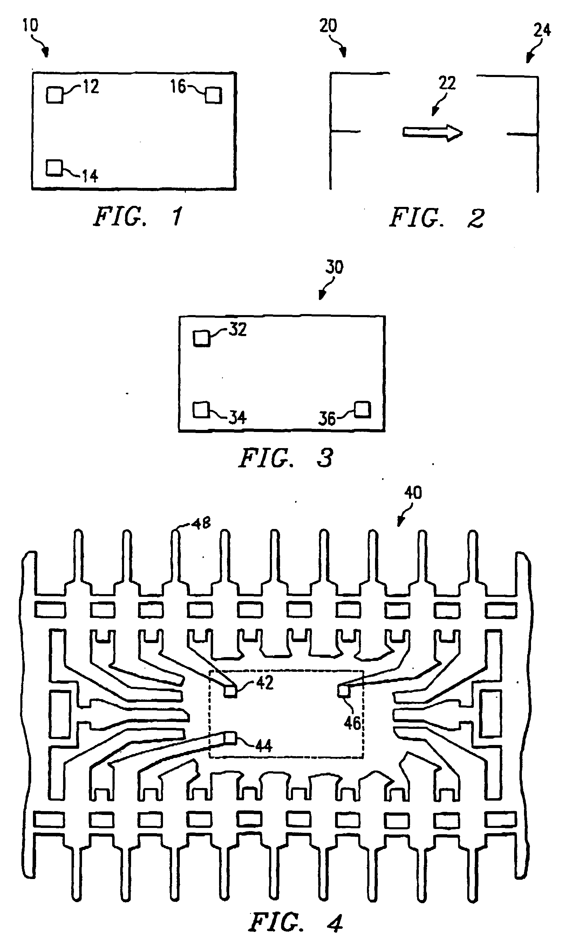

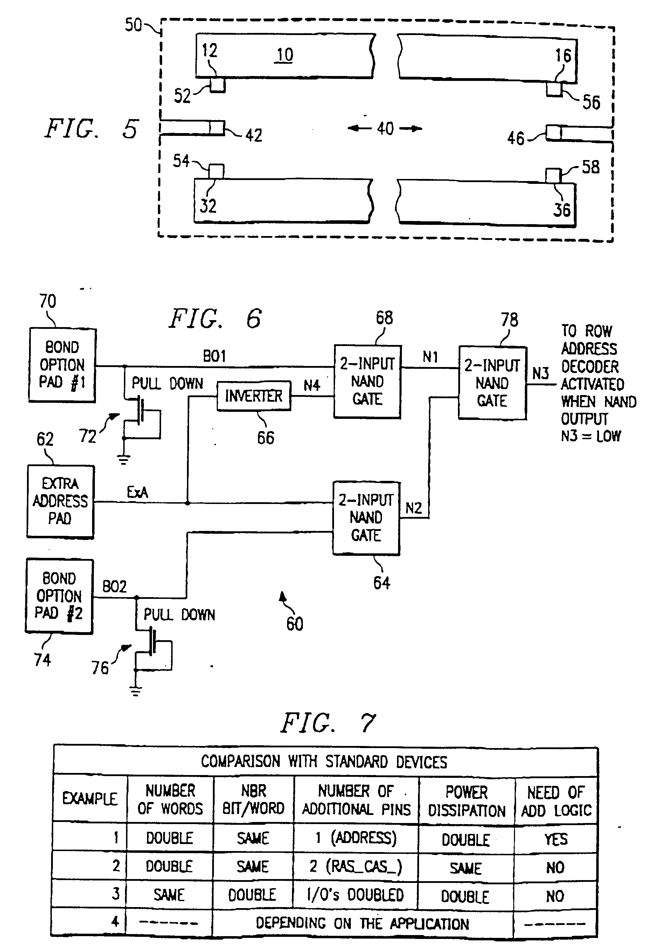

FIGURE 1 shows a first semiconductor memory chip 10 having a first set of pads including, for example, pad 12, pad 14, and pad 16 that may be formed according to a predetermined set of masks (not shown). Known memory device fabrication techniques may be employed to yield the device of FIGURE 1. The top plan view shows, for example, that semiconductor memory device 10 may be a DRAM. The active devices of first chip 10 are connected, for example, to pads 16 for external connection to a lead frame (see FIGURE 4). FIGURE 1 depicts original pads 12, 14 and 16 located at three locations of chip 10. On each of the bond pads may be formed bumps (see FIGURE 5, below) that permit a flat or substantially flat lead frame to electrically connect to the circuitry of semiconductor memory chip 10.

FIGURE 2 shows conceptually the generation of a second set of masks in which the original chip is mirrored according to the teachings of the present invention. It is possible to construct a mirror image of the circuitry of semiconductor memory chip 10 by manipulating the instructions that control the patterning of the photolithography masks for the original device. In other words, by inverting the axis of orientation from which the precise points of the photolithographic mask are determined or otherwise developing an inverted image, the mirror image results.

Consider, therefore, in FIGURE 2, that the letter "F" represents the original orientation of a photolithographic mask for semiconductor memory chip 10 of FIGURE 1. Then, by manipulation of the instructions and data for generating the photolithographic mask for the letter "F," as arrow 22 indicates, the "inverted-F" at 24 results.

FIGURE 3 illustrates a second semiconductor memory chip 30 having a second set of pads and formed from the set of mirror-imaged masks that were formed per the concepts of FIGURE 2. FIGURE 3, for example, shows pad 32, pad 34, and pad 36, which are positioned at the mirror image of locations for pad 12, pad 14, and pad 16 in memory chip 10 of FIGURE 1.

FIGURE 4 shows a lead frame 40 that may be formed to contact the pads of both semiconductor memory chip 10 and those of semiconductor memory chip 30. Lead frame 40 includes a plurality of contacts, such as contact 42, contact 44, and contact 46, that can electrically engage the pad bumps for each chip. Each of the plurality of contacts connect to an associated lead of lead frame 40.

FIGURE 5 shows in cross section first semiconductor memory chip 10 and the second semiconductor memory chip 30 bonded to single package lead frame 40 according to the teachings of the present invention. Using the bump bonding technology, permits assembly of the two semiconductor memory chips in the same package represented conceptually by dash-line 50 having the two semiconductor memory chips 10 and 30 facing the contacts 42 and 46 of frame 40 from opposed sides. In this way, bumps 52 and 54 of the pads 12 and 32, respectively, will have the same position, with reference to the related contact. Likewise, bump 56 for pad 16 and bump 58 for pad 36 both connect to contact 46 of frame 40.

In the preferred embodiment, pads not expected to be connected to the facing lead contact may be formed with no bumps on them and may, instead be covered with a protective oxide. The bonding of either pair of homologous bumps on the same pad, or single bumps to a dedicated pad of the semiconductor memory chip nay be made according to the chosen architecture, as exemplified in various DRAM devices.

FIGURE 6 depicts a structure illustrating how a single-packaged semiconductor memory device may be controlled. As FIGURE 5 indicates, two semiconductor memory chips 10 and 30 are single packaged together to form double capacity memory package 50. To allow this configuration, this embodiment adds to the basic semiconductor memory chip, onto the same die, an Extra Address pad 62, two Bond Option pads 70 and 74, and associated logic circuitry 60. Therefore, the semiconductor memory chips 10 and 30 may work as a standard memory chip when used separately, or, when combined, may make the double memory chip in FIGURE 5 forming double capacity memory package 50, according the way the Bond Option pads 70 and 74 are used.

Referring to FIGURE 6, logic circuitry 60 includes Extra Address pad 62 that connects to 2-input NAND gate 64 and inverter 66. The inverter 66 output N4 goes to 2-input NAND gate 68. Bond option pad 70 output is controlled by pull-down transistor 72 to provide an input to 2-input NAND gate 68. Bond option pad 74 is controlled by pull-down transistor 76 to provide input to 2-input NAND gate 64. The N1 output from 2-input NAND gate 68 goes, along with N2 output from 2-input NAND gate 64, to 2-input NAND gate 78. The result is N3 output from 2-input NAND gate 78 that goes to a Row Address Decoder which activates when NAND output N3 is low (the Row Address Decoder is a standard circuitry present in all semiconductor memory devices that, when activated, enables operations on the Memory Row specified by the Row Address).

FIGURE 7 provides a table summarizing the operations that logic circuitry 60 makes possible. Referring to both FIGUREs 6 and 7, if Bond Option pad 70 is bonded to V_{CC} (i.e., to the logic value "1"), N1 output of 2-input NAND gate 68 no longer depends from BO1 input. If, in addition, Bond Option pad 74 is connected to ground (or left unconnected, being that equivalent because of the pull-down transistor 76), N2 output of 2-input NAND gate 64 is always 1, regardless of the Extra Address pad 62 logic value. In this case, the N3 output of 2-input NAND gate 78 is the reverse logic value of N1 input, that, because BO1 is always 1, is equal to the reverse value of the N4 output of inverter 66.

The N4 output of the inverter 66 is the reverse value of Extra Address pad 62. The N3 output, therefore, is ultimately equal to the reverse value of Extra Address pad 62. That means that the device having Bond Option pad 70 connected to V_{cc} and Bond Option pad 74 connected to GND or left open (e.g. semiconductor memory chip 10 in FIGURE 5) will be accessed when Extra Address pad 62 is 1 (i.e., the N3 equaling zero). On the other hand, if Bond Option pad 70 is connected to GND (or left unconnected, being equivalent because of the pull-down transistor 72), N1 output of 2-input NAND gate 68 is always a logic 1, regardless of the Extra Address pad 62 logic value.

If, in addition, Bond Option pad 74 is connected to V_{cc}, the N2 output of 2-input NAND gate 64 is equal to the reverse of the Extra Address pad 62 logic value. Accordingly, the N3 is ultimately equal to the logic value of Extra Address pad 62, making the N1 output always equal 1. That means the device having Bond Option pad 70 connected to ground or left open and Bond Option pad 74 connected to V_{cc}, (e.g., semiconductor memory chip 30 in FIGURE 5) will be accessed when Extra Address pad 62 is zero (again, the N3 output from 2-input NAND gate 78 equals to zero). This allows access to semiconductor memory chip 10 or 30 in double capacity memory package 50, according the logic value of Extra Address pad 62.

In double capacity memory package 50, in this case all the homologous pads of the two chips, Extra Address pads 62 included, will be connected together by double bonding to the homologous bumps 18 and 38 of the respective memory chips. The package will need one only extra pin to allow to access Extra Address pads. The number of words will double, while the number of bits per word will remain the same. RAS_ and CAS_ signals can be operated without any change at board level, while taking into account the number of Rows is doubled.

Referring again to FIGURE 6, the semiconductor memory device of the illustrative embodiment works as a standard memory chip when both the BO1 input to 2-input NAND gate 68 and BO2 input to 2-input NAND gate 64 are low. This occurs either if Bond Option pads 70 and 74 are both connected to GND, or if Bond Option pads 70 and 74 are both left unconnected because of the presence of the pull-down transistors 72 and 76). In this case, the N3 output from 2-input NAND gate 78 will be low, regardless of the value of the output from Extra Address pad 62. In other words, in this case the semiconductor memory device will operate without the double capacity feature, and can be used as a standard semiconductor memory device.

In the same case of both BO1 and BO2 inputs being low, logic circuitry 60 may allow doubling the number of words having the same number of bits per word by simply the duplication of RAS_ and CAS_ pins. In this case, the two semiconductor memory chips 10 and 30 in FIGURE 5 may be packaged into a double capacity memory package 50 having two additional pins to allow separate bonding of RAS_ and CAS_ pads of each memory chip. All other pins will have double bonding to the homologous bumps 18 and 38 of the respective memory chips. By operating separately RAS_ and CAS_ for each memory chip, each memory chip may be accessed independently. This makes power dissipation remain nearly the same as in the original memory chip, if each of the chips is accessed alternatively. Moreover, this configuration does not require "per se" any design change and, in this case, logic circuitry 60 is not strictly needed.

Logic circuitry 60 also provides a double capacity memory option that has same number of words and double number of bits per word. This doubles the memory capacity obtained by doubling the Inputs/Outputs pins. In this case, the two semiconductor memories 10 and 30 will be packed into a double capacity memory package 50 having as many additional pins as the bits per word of the basic die. For example, four additional pins may be needed if the DRAMs are organized in a by-four (x4) configuration to generate a by-eight (x8) part, or 8 additional pins if the DRAMs are organized in a x8 configuration to generate by-sixteen (x16) part. All I/O (Dqx) pads will be single bonded separately, while all the remaining homologous pads will be double bonded to the same pin. The resulting part can be operated exactly as the basic device, without any change in the board design, the only difference consisting in the double number of bits per words. In this case the power dissipation will be nearly double that of the original memory chip. Also, this configuration does not, in and of itself, require any design change nor does it require logic circuitry 60.

Although the invention has been described herein with reference to the illustrative embodiments, it is to be understood that this description is by way of example only and is not to be construed in a limiting sense. It is to be further understood, therefore, that numerous changes in the details of the embodiments of the invention and additional embodiments of the invention, will be apparent to, and may be made by, persons of ordinary skill in the art having reference to this description.

## Claims

1. A method of assembling a packaged semiconductor device comprising the steps of:
providing a first device comprising a first set of pads;
providing a second device comprising a second set of pads, said second set of pads being formed according to a mirror-image of said first set of pads;
connecting said first device and said second device to a lead frame such that said first device and said second device active regions substantially face opposite sides of said lead frame for a predetermined set of functionally equivalent ones of said first set of pads and said second set of pads to thereby share a common lead of said lead frame.

2. The method of Claim 1 further comprising:
performing said providing and connecting steps for doubling the memory capacity of said packaged semiconductor device.

3. The method of Claim 1 or Claim 2 further comprising:
forming said first set of pads according to at least a first mask;
generating at least a second mask comprising a mirror-image of the or each first mask;
forming said second set of pads according to the or each second mask.

4. The method of any preceding Claim, further comprising forming a first and a second set of bumps such that said first set of pads is associated with said first set of bumps and said second set of pads associated with said second set of bumps, and connecting said first set of bumps and said second set of bumps to said lead frame.

5. The method of any preceding Claim, further comprising the step of forming control circuitry for permitting the selective control of said packaged semiconductor memory device and operating as a single capacity memory device or a double capacity memory device.

6. The method of any of Claims 1 to 5, further comprising the step of forming control circuitry associated with said first device and said second device for providing memory capacity for double the number of words with an equivalent number of bits per word as a single memory chip.

7. The method of any of Claims 1 to 5, further comprising the step of forming control circuitry associated with said first device and said second device for providing memory capacity for an equivalent number of words and double the number of bits per word as a single memory chip.

8. A memory apparatus, comprising:
a first memory device having a first set of pads and a first predetermined capacity;
a second memory device comprising a mirror image of said first memory device having a second set of pads and a second predetermined capacity approximately equal to said first predetermined capacity;
a lead frame for selectively connecting to either said first memory device, said second memory device, or both said first memory device and said second memory device;
selected active regions of said first memory device connected to selected active areas of said second memory device; and
control circuitry for controlling the operation of said memory apparatus.

9. The apparatus of Claim 8, wherein said first set of pads is associated with a first set of bumps and said second set of pads is associated with a second set of bumps, said first set of bumps and said second set of bumps connected to said lead frame.

10. The apparatus of Claim 8 or Claim 9, wherein said control circuitry permits the selective control of said memory apparatus to operate as a single capacity memory device or a double capacity memory device.

11. The apparatus of any of Claims 8 to 10, wherein said control circuitry further comprises circuitry associated with said first device and said second device for providing memory capacity having double the number of words with an equivalent number of bits per word as a single memory chip of said first predetermined capacity.

12. The apparatus of any of Claims 8 to 10, wherein said control circuitry further comprises circuitry associated with said first device and said second device for providing memory capacity having an equivalent number of words with a double number of bits per word as a single memory chip of said first predetermined capacity.

13. A semiconductor memory device, comprising:
a first device comprising a first set of pads;
a second device comprising a second set of pads, said second set of pads being formed according to a mirror image of said first set of pads;
a lead frame for connecting to said first device and said second device so that said first device and said second device active regions face substantially opposite sides of said lead frame for functionally equivalent ones of said first set of pads and said second set of pads to share a common lead of said lead frame.

14. The device of Claim 13, wherein said first set of pads is associated with a first set of bumps and said second set of pads is associated with a second set of bumps, wherein said first set of bumps and said second set of bumps are bonded to said lead frame.

15. The device of Claim 13 or Claim 14, further comprising an address pad for permitting the selective control of said semiconductor memory device to operate as a single capacity memory device or a double capacity memory device.

16. The device of any of Claims 13 to 15, further comprising control circuitry for electronically controlling the selection of whether said single package semiconductor memory device operates as a single Capacity memory device or a double capacity memory device.

17. A double memory capacity device, comprising:
a first single capacity memory device;
a second single capacity memory device comprising a mirror image of said first single capacity memory device;
a lead frame for selectively connecting to either said first single capacity memory device, said second single capacity memory device, or both said first single capacity memory device and said second single capacity memory device; and
said first single capacity memory device and said second single capacity memory device connected to said lead frame.

18. The device of Claim 17, further comprising an address pad for permitting the selective control of said single package semiconductor memory device to operate as a single capacity memory device or a double capacity memory device.

19. The device of Claim 17 or Claim 18, further comprising control circuitry for controlling the selection of whether said single package semiconductor memory device operates as a single capacity memory device or a double capacity memory device.
